# EUROPÄISCHE PATENTSCHRIFT

(11) **EP 4 285 700 B1**
(45) Veröffentlichungstag und Bekanntmachung des Hinweises auf die Patenterteilung: **07.08.2024**
(21) Anmeldenummer: 22726450.4
(22) Anmeldetag: 29.04.2022
(51) Int. Cl.: H05K 9/00

(54) **DÄMPFUNGSFOLIE UND VERFAHREN ZUM HERSTELLEN EINER DÄMPFUNGSFOLIE**
DAMPING FILM AND METHOD OF MAKING DAMPING FILM
FILM AMORTISSANT ET PROCEDE DE FABRICATION D'UN FILM AMORTISSANT

(30) Priorität: 30.04.2021 DE 102021111286
(43) Veröffentlichungstag der Anmeldung: 06.12.2023
(73) Patentinhaber: Magnetec GmbH, 63457 Hanau (DE)
(72) Erfinder: WENTZLIK, Thomas, 60385 Frankfurt Main (DE)
(74) Vertreter: Richly & Ritschel Patentanwälte PartG mbB
(86) Internationale Anmeldenummer: PCT/EP2022/061497
(87) Internationale Veröffentlichungsnummer: WO 2022/229393

(56) Entgegenhaltungen:
- EP-B1- 1 051 714
- EP-B1- 2 797 092
- WO-A1-2010/140367
- WO-A1-2015/147449
- WO-A1-2018/004262
- CN-A- 111 698 898
- DE-A1- 102012 109 744
- DE-A1- 102013 103 268
- DE-U1- 202005 022 087
- US-A1- 2011 210 696
- BOLL R ED - BOLL R: "Weichmagnetische Werkstoffe", 1 January 1990, WEICHMAGNETISCHE WERKSTOFFE. EINFUHRING IN DEN MAGNETISMUS VAC-WERKSTOFFE UND IHRE ANWENDUNGEN, HANAU, VACUUMSCHMELZE GMBH, DE, PAGE(S) 171 - 174, ISBN: 978-3-8009-1546-0, XP002102087

## Beschreibung

Die Erfindung betrifft eine Dämpfungsfolie und ein Verfahren zum Herstellen einer Dämpfungsfolie.

Insbesondere betrifft die Erfindung eine Dämpfungsfolie, einen Gegenstand mit einer Batterie, einer Empfängerspule zum kabellosen Empfangen von Energie und einer Dämpfungsfolie, einen Gegenstand mit einer Sendespule zum kabellosen Senden von Energie an eine Empfängerspule und einer Dämpfungsfolie, ein Verfahren zum Herstellen einer Dämpfungsfolie und eine Verwendung einer Dämpfungsfolie.

Ein kabelloses Ladeverfahren wird verwendet, um eine Batterie eines mobilen Geräts aufzuladen, ohne dass das mobile Gerät mit einer Stromquelle mittels einer mechanischen Verbindung wie einem Kabel und/oder einem Stecker verbunden ist.

Beim kabellosen Laden wird die Energie mittels einem elektromagnetischen Feld von einer Sendespule zu einer Empfängerspule übertragen. Dieses elektromagnetische Feld kann neben der Empfängerspule aber auch andere elektronische Geräte und weitere Komponenten beeinflussen, wodurch ungewollte Reaktionen hervorgerufen werden und Beschädigungen auftreten können.

Eine Dämpfungsfolie kann dazu verwendet werden die Ausbreitung des elektromagnetischen Feldes zu dämpfen, sodass eine Wirkung des elektromagnetischen Feldes auf andere elektronische Geräte und weitere Komponenten vermindert oder verhindert werden kann.

EP 2 797 092 B1, US 2011/210696 A1, WO 2010/140367 A1, DE 10 2013 103268 A1 und CN 111 698 898 A offenbaren Abschirmfolien, die Substratschichten umfassen, zwischen denen eine Magnetschicht haftend eingefügt ist.

EP 1 051 714 B1, DE 20 2005 022087 U1 und DE 10 2012 109744 A1 offenbaren Materialien, die zu Abschirmzwecken mit Koerzitivfeldstärken unter 10 A/m verwendet werden.

WO 2015/147449 A1 offenbart die Notwendigkeit einer Abschirmschicht, deren Materialien so beschaffen sind, dass ein optimaler Kompromiss zwischen Abschirmkapazität und Wärmeübertragung erzielt wird.

Der Erfindung liegt die Aufgabe zugrunde, dem Stand der Technik eine Verbesserung oder eine Alternative zur Verfügung zu stellen.

Nach einem ersten Aspekt der Erfindung löst die Aufgabe eine Dämpfungsfolie, insbesondere eine Dämpfungsfolie zur Abschirmung eines elektronischen Geräts vor einem elektrischen und/oder magnetischen Feld, insbesondere Dämpfungsfolie zur Abschirmung eines elektronischen Geräts mit Komponenten zum kabellosen Laden vor einem elektrischen und/oder magnetischen Feld, aufweisend:
- eine erste Trägerschicht;
- eine erste Adhäsionsschicht, welche unmittelbar mit der ersten Trägerschicht kontaktiert ist;
- eine Dämpfungsschicht, welche unmittelbar mit der ersten Adhäsionsschicht kontaktiert ist, wobei die Dämpfungsschicht ein Dämpfungsmaterial bestehend aus einem weichmagnetischen Stoff aufweist;
- eine zweite Adhäsionsschicht, welche unmittelbar mit der Dämpfungsschicht kontaktiert ist, insbesondere auf der abgewandten Seite der ersten Adhäsionsschicht unmittelbar mit der Dämpfungsschicht kontaktiert ist; und
- eine zweite Trägerschicht, welche unmittelbar mit der zweiten Adhäsionsschicht kontaktiert ist;
- und das Dämpfungsmaterial eine Koerzitivfeldstärke von kleiner oder gleich 2 A/m aufweist, bevorzugt eine Koerzitivfeldstärke von kleiner oder gleich 1,5 A/m und besonders bevorzugt eine Koerzitivfeldstärke von kleiner oder gleich 1 A/m aufweist.

### Begrifflich sei hierzu Folgendes erläutert:

Zunächst sei ausdrücklich darauf hingewiesen, dass im Rahmen der hier vorliegenden Patentanmeldung unbestimmte Artikel und Zahlenangaben wie "ein", "zwei" usw. im Regelfall als "mindestens"-Angaben zu verstehen sein sollen, also als "mindestens ein...", "mindestens zwei ..." usw., sofern sich nicht aus dem jeweiligen Kontext ausdrücklich ergibt oder es für den Fachmann offensichtlich oder technisch zwingend ist, dass dort nur "genau ein ...", "genau zwei ..." usw. gemeint sein können.

Im Rahmen der hier vorliegenden Patentanmeldung sei der Ausdruck "insbesondere" immer so zu verstehen, dass mit diesem Ausdruck ein optionales, bevorzugtes Merkmal eingeleitet wird. Der Ausdruck ist nicht als "und zwar" und nicht als "nämlich" zu verstehen.

Unter einer "Dämpfungsfolie" wird eine Verbundfolie aufweisend mehrere zumindest paarweise untereinander verbundene Schichten verstanden, welche dazu eingerichtet ist, ein elektrisches und/oder magnetisches Feld hinsichtlich seiner Ausbreitung zu dämpfen, sodass ausgehend von einer Quelle für ein elektrisches und/oder magnetisches Feld hinter der Dämpfungsfolie angeordnete elektronische Geräte vor dem elektrischen und/oder magnetischen Feld abgeschirmt werden können. Auf diese Weise kann die Einwirkung eines elektrischen und/oder magnetischen Feldes auf von der Dämpfungsfolie geschützte elektronische Geräte und/oder Komponenten stark reduziert oder verhindert werden.

Unter "Dämpfung" wird verstanden, dass die Leistung eines elektrischen und/oder magnetischen Feldes abnimmt, insbesondere die elektrische Leistung und/oder die magnetische Leistung.

Eine "Trägerschicht" wird als eine strukturgebende Schicht in dem Schichtverbund der Dämpfungsfolie verstanden, welche dazu eingerichtet ist, einer angrenzenden vergleichsweise weichen Adhäsionsschicht und/oder der mittelbar angrenzenden Dämpfungsschicht aufweisend ein vergleichsweise sprödes Dämpfungsmaterial im Schichtverbund eine höhere Zugfestigkeit und/oder eine Druckfestigkeit zu vermitteln. Hierdurch kann eine vergleichsweise elastische und damit flexible Abschirmfolie erreicht werden, welche sich um abzuschirmende elektronische Geräte und/oder abweichenden Komponenten wickeln, in nahezu beliebigen Formen zuschneiden und an die Form eines abzuschirmenden elektronischen Geräts und/oder einer anderen Komponente anpassen lässt.

Gleichermaßen kann durch eine Trägerschicht vorteilhaft verhindert werden, dass die Abschirmfolie als Materialverbund gesamtheitlich bewertet spröde Materialeigenschaften aufweist, auch wenn die Dämpfungsschicht separat bewertet spröde Materialeigenschaften aufweist. Zusätzlich kann mittels einer entsprechend ausgewählten Trägerschicht auch die Scherfestigkeit der Dämpfungsfolie optimiert werden.

Vorzugsweise sei bei einer Trägerschicht unter anderem an eine Kunststofffolie und/oder eine Gewebeschicht gedacht.

Unter einer "Adhäsionsschicht" wird eine Schicht aus einem Adhäsionsmaterial verstanden, insbesondere eine Schicht aus einem Adhäsionsmittel, welche dazu eingerichtet ist, zwei an die Adhäsionsschicht angrenzende Schichten miteinander zu verbinden.

Eine "Dämpfungsschicht" wird als eine Schicht innerhalb der Dämpfungsfolie verstanden, welche ein Dämpfungsmaterial aufweist.

Unter einem "Dämpfungsmaterial" wird vorzugsweise ein weichmagnetischer Stoff mit einer Permeabilität von mehr oder gleich 500 H/m verstanden.

Vorzugsweise weist ein Dämpfungsmaterial geringe Wirbelstromverluste auf, wodurch die Güte der von dem Dämpfungsmaterial ausgehenden Abschirmwirkung vorteilhaft erhöht werden kann. Insbesondere bei hochfrequenten elektrischen und/oder magnetischen Feldern führen geringe Wirbelstromverluste des Dämpfungsmaterials zu einer vorteilhaften Dämpfungswirkung.

Unter anderem kann durch geringe Wirbelstromverluste des Dämpfungsmaterials vorteilhaft erreicht werden, dass sich die Dämpfungsfolie nicht stark aufheizt bzw. ihre Temperatur beibehält oder nur geringfügig ansteigt.

Weiterhin führt die vergleichsweise hohe Permeabilität eines weichmagnetischen Stoffes dazu, dass ein auf das weichmagnetische Material einwirkendes elektrisches Feld besonders effizient in ein magnetisches Feld umgewandelt werden kann und umgekehrt. Auf diese Weise können elektrisches Feld und magnetisches Feld ihre Energie besonders effizient austauschen, wodurch die Dämpfungswirkung besonders unterstützt wird.

Unter einem "weichmagnetischen Stoff" wird ein Stoff verstanden, welcher sich in einem Magnetfeld leicht magnetisieren lässt. Vorzugsweise weist ein weichmagnetischer Stoff eine Koerzitivfeldstärke von weniger gleich 1.000 A/m auf.

Unter der "Koerzitivfeldstärke" wird die magnetische Feldstärke verstanden, die notwendig ist, um ein zuvor bis zur Sättigungsflussdichte aufgeladenes Dämpfungsmaterial vollständig zu entmagnetisieren.

Vorzugsweise weist ein weichmagnetischer Stoff, insbesondere ein amorpher weichmagnetischer Stoff, eine Legierung aufweisend Eisen, Nickel und/oder Cobalt auf.

Hier wird eine Dämpfungsfolie vorgeschlagen, welche einen Verbund aus mehreren Materialschichten aufweist. Dämpfend auf ein elektrisches und/oder magnetisches Feld wirkt dabei insbesondere die Dämpfungsschicht aufweisend einen weichmagnetischen Stoff als Dämpfungsmaterial.

Durch den Verbund mehrere unterschiedlicher Materialschichten zu einer Dämpfungsfolie und/oder die Materialauswahl für die jeweiligen Schichten können die Eigenschaften der Dämpfungsfolie vorteilhaft optimiert werden. Hierdurch kann eine Dämpfungsfolie erreicht werden, welche gleichzeitig elastisch und schneidfähig ist und weiterhin eine besonders effiziente Dämpfung eines elektrischen und/oder magnetischen Feldes erlaubt.

Bei erster Trägerschicht und erster Adhäsionsschicht kann unter anderem an einen Klebestreifen gedacht sein, welcher bereits einen Verbund aus erster Trägerschicht und erster Adhäsionsschicht bereitstellt. Dieser Gedanke kann auch auf die zweite Trägerschicht und die zweite Adhäsionsschicht analog übertragen werden.

Insbesondere die Kombination der Dämpfungsfolie aus einer mit der Dämpfungsschicht verbundenen ersten Trägerschicht und der mit der Dämpfungsschicht verbundenen zweiten Trägerschicht ermöglicht vorteilhaft, dass die hier vorgeschlagene Dämpfungsfolie eine besonders gute Schneidbarkeit aufweist, sodass diese geometrisch exakt an die designierten Einsatzbedingungen angepasst werden kann. Versuche haben unerwartet gezeigt, dass die Schneidbarkeit durch einen Verbund aus erster Trägerschicht, Dämpfungsschicht und zweiter Trägerschicht eine erheblich verbesserte Schneidbarkeit aufweist, insbesondere können hierdurch erheblich glattere Schnittkanten auch bei komplexen Schnittverläufen vorteilhaft erreicht werden.

Zweckmäßig weist das Dämpfungsmaterial der Dämpfungsschicht projiziert in Normalenrichtung der ersten Trägerschicht eine Querschnittsfläche von mehr oder gleich 80 % der Querschnittsfläche der ersten Trägerschicht auf, bevorzugt von mehr oder gleich 87,5 % und besonders bevorzugt von mehr oder gleich 92,5 %.

Weiterhin zweckmäßig weist das Dämpfungsmaterial der Dämpfungsschicht projiziert in Normalenrichtung der ersten Trägerschicht eine Querschnittsfläche von mehr oder gleich 95 % der Querschnittsfläche der ersten Trägerschicht auf, bevorzugt von mehr oder gleich 97,5 % und besonders bevorzugt von mehr oder gleich 99 %.

Hier wird vorgeschlagen, dass die Dämpfungsschicht das Dämpfungsmaterial nicht vollflächig aufweist, sondern die Dämpfungsschicht vielmehr aus einer Draufsicht auf die Dämpfungsfolie nur teilflächig das Dämpfungsmaterial aufweist.

Unter anderem sei hierbei daran gedacht, dass das Dämpfungsmaterial in Streifen vorgesehen ist, welche parallel zueinander ausgerichtet sind und jeweils einen Abstand zueinander aufweisen.

Weiterhin sei konkret daran gedacht, dass das Dämpfungsmaterial partikelförmig ausgestaltet ist und die Partikel in der Dämpfungsschicht verteilt zueinander angeordnet sind.

Ausdrücklich sei darauf hingewiesen, dass eine Dämpfungsschicht auch Streifen und/oder Partikel des Dämpfungsmaterial aufweisen kann, wobei die Partikel und/oder die Streifen anderweitig relativ zueinander angeordnet sind, ohne diesen Aspekt zu verlassen.

Bevorzugt weist die Dämpfungsschicht eine Lage aus mehreren Streifen des Dämpfungsmaterials auf.

### Begrifflich sei hierzu Folgendes erläutert:

Unter einer "Lage" wird eine Anordnung von Streifen aufweisend das Dämpfungsmaterial verstanden, welche geordnet zueinander angeordnet sind, vorzugsweise parallel zueinander angeordnet sind, wobei sich die Streifen entweder überhaupt nicht überlappen oder nur geringfügig überlappen. Mit anderen Worten sind die Streifen innerhalb einer Lage in nur einer Ebene angeordnet, wobei eine geringfügige Überlappung der Streifen an ihren Stoßkanten zueinander ermöglicht bleibt.

Unter einem "Streifen" des Dämpfungsmaterials wird eine dünne Folie oder ein dünnes Band mit einer maximalen Dicke von 50 µm verstanden.

Vorzugsweise weist ein Streifen eine Dicke von weniger oder gleich 40 µm auf, bevorzugt eine Dicke von weniger oder gleich 30 µm und besonders bevorzugt eine Dicke von weniger oder gleich 25 µm. Weiterhin vorzugsweise weist ein Streifen eine Dicke von weniger oder gleich 20 µm auf, bevorzugt eine Dicke von weniger oder gleich 15 µm und besonders bevorzugt eine Dicke von weniger oder gleich 12 µm.

Vorzugsweise weist ein Streifen eine Breite von kleiner oder gleich 30 mm auf, bevorzugt eine Breite von kleiner oder gleich 25 mm und besonders bevorzugt eine Breite von kleiner oder gleich 20 mm. Weiterhin vorzugsweise weist ein Streifen eine Breite von kleiner oder gleich 15 mm auf, bevorzugt eine Breite von kleiner oder gleich 12,5 mm und besonders bevorzugt eine Breite von kleiner oder gleich 10 mm.

Hier wird eine Dämpfungsfolie mit einer Dämpfungsschicht vorgeschlagen, wobei die Dämpfungsschicht eine Lage aus mehreren Streifen des Dämpfungsmaterials aufweist, insbesondere genau eine Lage aus mehreren Streifen des Dämpfungsmaterials aufweist.

Die Güte der Dämpfung kann durch die Anordnung mehrerer Streifen in einer Lage anstelle einer durchgängigen Folie aus einem weichmagnetischen Stoff vorteilhaft weiter gesteigert werden.

Ausdrücklich sei darauf hingewiesen, dass die vorstehenden Werte für die Dicke und/oder die Breite eines Streifens nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Dicke und/oder Breite eines Streifens liefern.

Gemäß einer zweckmäßigen Ausführungsform weisen zwei Streifen des Dämpfungsmaterials einen Abstand von weniger oder gleich 0,2 mm zueinander auf, bevorzugt einen Abstand von weniger oder gleich 0,1 mm und besonders bevorzugt einen Abstand von weniger oder gleich 0,05 mm.

Durch getrennte Streifen können die Wirbelströme in der Dämpfungsschicht räumlich eingeschränkt werden und es kommt zu einer Domänenverfeinerung. Außerdem sind die weichmagnetischen Eigenschaften wegen der differenzierbaren Hystereseschleife isotrop, sodass Magnetfelder aus unterschiedlichen Richtungen abgeschirmt werden können.

Weiterhin bevorzugt grenzen zwei Streifen des Dämpfungsmaterials unmittelbar aneinander an, insbesondere grenzen zwei benachbarte Streifen des Dämpfungsmaterials über ihre gesamte Längserstreckung unmittelbar aneinander an.

Ausdrücklich sei darauf hingewiesen, dass die vorstehenden Werte für den Abstand nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe des hier vorgeschlagenen Abstands liefern.

Gemäß einer alternativen Ausführungsform überlappen sich zwei Streifen des Dämpfungsmaterials um mehr oder gleich 0,2 mm, bevorzugt um weniger als 0,2 mm und besonders bevorzugt um weniger oder gleich 0,1 mm, insbesondere über ihre gesamte Längserstreckung.

Die Anordnung der sich überlappenden Streifen der Dämpfungsfolie kann vorteilhaft dazu führen, dass die Flussleitung von Streifen zu Streifen verbessert werden kann und dadurch die Abschirmleistung erhöht werden kann.

Ausdrücklich sei darauf hingewiesen, dass die vorstehenden Werte für die Überlappung nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Überlappung liefern.

Gemäß einer besonders bevorzugten Ausführungsform weist die Dämpfungsschicht Partikel des Dämpfungsmaterials auf.

### Begrifflich sei hierzu Folgendes erläutert:

Unter einem "Partikel" wird ein Körper verstanden, welcher gegenüber der Dämpfungsfolie klein ist. Vorzugsweise wird unter einem Partikel ein Körper verstanden, welcher in jeder Raumrichtung eine Erstreckung in einem Bereich zwischen 3 µm und 200 µm aufweist.

Hier sei an eine Dämpfungsschicht aufweisend Partikel aus dem weichmagnetischen Stoff gedacht.

Vorzugsweise sind die Partikel in der Dämpfungsschicht verteilt zueinander angeordnet.

Weiterhin vorzugsweise weist die Dämpfungsschicht bestehend aus Partikeln eines weichmagnetischen Materials eine Dicke von größer oder gleich 10 µm und kleiner oder gleich 40 µm auf.

Konkret sei auch daran gedacht, dass die Partikel in der Dämpfungsschicht mittels einem Matrixmaterial gebunden sind.

Unter einem "Matrixmaterial" wird ein Material verstanden in welchem die Partikel des weichmagnetischen Stoffes gelöst werden können.

Unter dem Lösen der Partikel des weichmagnetischen Stoffes in dem Matrixmaterial wird verstanden, dass die Partikel unter Beibehaltung ihrer stofflichen Zusammensetzung in ein im technischen Sinne weitestgehend homogenes Gemisch, welches neben den Partikeln zumindest ein Lösungsmittel für die Partikel aufweist, insbesondere zumindest das Matrixmaterial aufweist, überführt werden oder worden sind. Dabei sei daran gedacht, dass das Lösungsmittel die Partikel umgibt und die Partikel durch adhäsive Wechselwirkungen an das Lösungsmittel gebunden sind.

Vorzugsweise weist das Lösungsmittel neben dem Matrixmaterial auch einen Füllstoff auf.

Bei dem Matrixmaterial sei vorzugsweise an einen flüssigen Stoff gedacht, insbesondere an einen flüssigen Stoff mit einem dilatanten oder newtonschen oder pseudoplastischen oder binghamplastischen oder casson-plastischen Fließverhalten.

Gemäß einer optionalen Ausführungsform wird oder ist das Matrixmaterial nach dem Lösen der Partikel ausgehärtet, insbesondere durch eine Reaktion zwischen dem Matrixmaterial und einem Härter. Unter anderem sei auch daran gedacht, dass die Dämpfungsfolie nach dem Anbringen durch den Einsatz von UV-Licht formfixiert wird, indem das Matrixmaterial der Dämpfungsschicht durch das UV-Licht ausgehärtet wird.

Zweckmäßig weisen die Partikel eine Erstreckung in einem Bereich von größer oder gleich 3 µm und kleiner oder gleich 200 µm auf, bevorzugt eine Erstreckung in einem Bereich von größer oder gleich 4 µm und kleiner oder gleich 100 µm und besonders bevorzugt eine Erstreckung in einem Bereich von größer oder gleich 5 µm und kleiner oder gleich 50 µm.

Weiterhin vorzugsweise weisen die Partikel eine Erstreckung in einem Bereich von größer oder gleich 7 µm und kleiner oder gleich 40 µm auf, bevorzugt eine Erstreckung in einem Bereich von größer oder gleich 8 µm und kleiner oder gleich 30 µm und besonders bevorzugt eine Erstreckung in einem Bereich von größer oder gleich 10 µm und kleiner oder gleich 20 µm.

Es versteht sich, dass die vorstehenden Bereichsgrenzen auch beliebig miteinander kombiniert werden können, ohne dabei diesen Aspekt der Erfindung zu verlassen.

Optional weist die Dämpfungsfolie eine dritte Adhäsionsschicht auf, bevorzugt eine auf der abgewandten Seite der ersten Adhäsionsschicht unmittelbar mit der ersten Trägerschicht kontaktierte dritte Adhäsionsschicht.

Durch die dritte Adhäsionsschicht kann vorteilhaft erreicht werden, dass die Dämpfungsfolie vergleichbar eines Klebestreifens an ihrem designierten Einsatzort fixiert werden kann.

Unter anderem kann bei einer ersten Trägerschicht aufweisend eine erste Adhäsionsschicht und eine dritte Adhäsionsschicht an ein doppelseitiges Klebeband gedacht werden.

Gemäß einer zweckmäßigen Ausführungsform weist die erste Trägerschicht und/oder die zweite Trägerschicht und/oder die erste Adhäsionsschicht und/oder die zweite Adhäsionsschicht und/oder die dritte Adhäsionsschicht eine Temperaturbeständigkeit von mehr oder gleich 80 °C auf, bevorzugt von mehr oder gleich 100 °C und besonders bevorzugt von mehr oder gleich 120 °C.

Weiterhin zweckmäßig weist die erste Trägerschicht und/oder die zweite Trägerschicht und/oder die erste Adhäsionsschicht und/oder die zweite Adhäsionsschicht und/oder die dritte Adhäsionsschicht eine Temperaturbeständigkeit von mehr oder gleich 150 °C auf, bevorzugt von mehr oder gleich 170 °C und besonders bevorzugt von mehr oder gleich 200 °C.

Durch die Dämpfung eines elektrischen und/oder magnetischen Feldes kann sich das Dämpfungsmaterial erwärmen. Diese entstehende Wärme kann sich auf eine Adhäsionsschicht und/oder eine Trägerschicht übertragen. Bei einer zu niedrigen Temperaturbeständigkeit kann es so zu einem Verrutschen und/oder zu einem Ablösen und/oder zu einer Beschädigung der Dämpfungsfolie kommen. Dem wirkt die hier vorgeschlagene Temperaturbeständigkeit entgegen.

Weiterhin sei auch daran gedacht, dass die hier vorgeschlagene Dämpfungsfolie an Einsatzorten verwendet können werden soll, welche eine höhere Temperatur aufweisen können. Dies kann durch die hier vorgeschlagene Temperaturbeständigkeit der Dämpfungsfolie erreicht werden.

Ausdrücklich sei darauf hingewiesen, dass die vorstehenden Werte für die Temperaturbeständigkeit nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Temperaturbeständigkeit liefern.

Bevorzugt weist das Dämpfungsmaterial eine Koerzitivfeldstärke von kleiner oder gleich 10 A/m auf, bevorzugt eine Koerzitivfeldstärke von kleiner oder gleich 5 A/m und besonders bevorzugt eine Koerzitivfeldstärke von kleiner oder gleich 3 A/m.

Vorzugsweise das Dämpfungsmaterial eine Koerzitivfeldstärke von kleiner oder gleich 0,5 A/m auf, bevorzugt eine Koerzitivfeldstärke von kleiner oder gleich 0,1 A/m und besonders bevorzugt eine Koerzitivfeldstärke von kleiner oder gleich 0,05 A/m.

Die oberhalb genannten Werte für die Koerzitivfeldstärke gelten bei einem mit 50 Hz oszillierenden Magnetfeld.

Durch eine geringe Koerzitivfeldstärke des Dämpfungsmaterials kann, insbesondere bei designierten Anwendungsfällen mit polaritätswechselnden Feldstärken die Dissipation in dem Dämpfungsmaterial reduziert werden, wodurch die thermische Stabilität zusätzlich erhöht werden kann.

Ausdrücklich sei darauf hingewiesen, dass die vorstehenden Werte für die Koerzitivfeldstärke des Dämpfungsmaterials nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen Koerzitivfeldstärke des Dämpfungsmaterials liefern.

Weiterhin bevorzugt weist das Dämpfungsmaterial eine Remanenz von kleiner oder gleich 0,1 T auf, bevorzugt eine Remanenz von kleiner oder gleich 0,05 T und besonders bevorzugt eine Remanenz von kleiner oder gleich 0,02 T.

Hierdurch kann die in dem Dämpfungsmaterial anfallende Dissipation bei polaritätswechselnden Feldstärken zusätzlich vorteilhaft reduziert werden.

Bevorzugt weist das Dämpfungsmaterial eine Sättigungsflussdichte von größer oder gleich 1 T auf, bevorzugt eine Sättigungsflussdichte von größer oder gleich 1,1 T und besonders bevorzugt eine Sättigungsflussdichte von größer oder gleich 1,2 T. Vorzugsweise weist das Dämpfungsmaterial eine magnetische Sättigungsflussdichte von größer oder gleich 1,3 T auf.

Mit steigender Sättigungsflussdichte kann vorteilhaft erreicht werden, dass das Dämpfungsmaterial für einen Referenzanwendungsfall kleiner dimensioniert werden kann, ohne dabei thermisch instabil zu werden, insbesondere da einhergehend mit der hohen Sättigungsflussdichte auch eine hohe Sättigungsfeldstärke erreicht werden kann. Mit anderen Worten führt eine vergleichsweise hohe Sättigungsflussdichte dazu, dass eine Erwärmung des Dämpfungsmaterials vermindert oder verhindert werden kann.

Ausdrücklich sei darauf hingewiesen, dass die vorstehenden Werte für die magnetische Sättigungsflussdichte des Dämpfungsmaterials nicht als scharfe Grenzen zu verstehen sein sollen, sondern vielmehr in ingenieurmäßigem Maßstab über- oder unterschritten werden können sollen, ohne den beschriebenen Aspekt der Erfindung zu verlassen. Mit einfachen Worten sollen die Werte einen Anhalt für die Größe der hier vorgeschlagenen magnetischen Sättigungsflussdichte des Dämpfungsmaterials liefern.

Besonders zweckmäßig ist der weichmagnetische Stoff ein metallisches Glas.

### Begrifflich sei hierzu Folgendes erläutert:

Unter einem "metallischen Glas" wird eine metallbasierte Legierung eines Stoffes verstanden, welche auf atomarer Ebene keine kristalline, sondern eine amorphe Struktur aufweist und trotzdem metallische Leitfähigkeit als Eigenschaft aufweist. Vorzugsweise kann ein metallisches Glas neben metallischen Legierungsbestandteilen auch nichtmetallische Legierungsbestandteile aufweisen.

Durch die für Metalle sehr ungewöhnliche amorphe Atomanordnung ermöglicht vorteilhaft besondere physikalische Stoffeigenschaften. Insbesondere kann durch die Verwendung von metallischen Gläsern die Koerzitivfeldstärke des Dämpfungsmaterials vorteilhaft reduziert werden und/oder die Permeabilität vorteilhaft erhöht werden. Zusätzlich können metallische Gläser einen hohen elektrischen Widerstand aufweisen, wodurch sich für einige Anwendungen des Dämpfungselements die von der Dämpfungsfolie hervorgerufenen Wirbelstromverluste vorteilhaft reduziert werden können.

Besonders bevorzugt weist der weichmagnetische Stoff eine nanokristalline Struktur auf.

### Begrifflich sei hierzu Folgendes erläutert:

Unter einem Material mit einer "nanokristallinen Struktur" wird ein polykristalliner Festkörper mit einer Nano-Mikrostruktur verstanden, wobei unter der Mikrostruktur die Art, die Kristallstruktur, die Anzahl, die Form und die topologische Anordnung von Punktdefekten, Versetzungen, Stapelfehlern und Korngrenzen in einem kristallinen Material verstanden wird.

Durch die nanokristalline Struktur lassen sich die physikalischen Eigenschaften des Dämpfungselements weiter verbessern. Insbesondere kann die Permeabilität des weichmagnetischen Stoffes erhöht werden.

Vorzugsweise wird ein nanokristallines Material aus einem amorphen Material hergestellt, wobei das Kristallwachstum ausgehend von dem amorphen Material durch Einwirkung einer thermischen und/oder magnetischen Einwirkung angeregt wird.

Vorzugsweise besteht das Dämpfungsmaterial aus einem weichmagnetischen Stoff mit einer nanokristallinen Struktur aufweisend eine typische Korngröße im Bereich von 5 µm bis 30 µm, bevorzugt aus einem nanokristallinen weichmagnetischen Stoff mit einer typischen Korngröße im Bereich von 7 µm bis 20 µm, besonders bevorzugt aus einem nanokristallinen weichmagnetischen Stoff mit einer typischen Korngröße im Bereich von 8 µm bis 15 µm. Hierdurch lassen sich besonders vorteilhafte physikalische Eigenschaften für das Dämpfungsmaterial erreichen, insbesondere im Hinblick auf die Permeabilität und/oder die Sättigungsfeldstärke.

Gemäß einer bevorzugten Ausführungsform weist der weichmagnetische Stoff folgende atomare Zusammensetzung auf:

[Feᵢ₁₋ₐNiₐ]_{100-x-y-z-α-β-γ} CUₓSi_{y}B_{z}Nb_{α}M'_{β}M"_{γ}

mit a ≤ 0,3, 0, 6 ≤ x ≤ 1,5, 10 ≤ y ≤ 17, 5 ≤ z ≤ 14, 2 ≤ α ≤ 6, β ≤ 7, γ ≤ 8, wobei M' mindestens eines der Elemente V, Cr, Co, Al und Zn ist, wobei M" mindestens eines der Elemente C, Ge, P, Ga, Sb, In und Be ist.

Laborversuche haben ergeben, dass die vorstehende Spezifikation des weichmagnetischen Stoffes zu besonders vorteilhaften Materialeigenschaften für das hier vorgeschlagene Dämpfungsmaterial führen.

Dabei kann durch die vorstehende stoffliche Spezifizierung insbesondere ein Dämpfungsmaterial mit einer besonders kleinen Koerzitivfeldstärke und/oder einer besonders hohen Sättigungsflussdichte erreicht werden.

Vorzugsweise weist der vorstehend spezifizierte weichmagnetische Stoff Nickel auf, insbesondere einen Nickelgehalt von größer oder gleich 4,5 Gew.-%, bevorzugt einen Nickelgehalt von größer oder gleich 5 Gew.-% und besonders bevorzugt einen Nickelgehalt von größer oder gleich 5,5 Gew.-%.

Zweckmäßig weist der weichmagnetische Stoff eine Magnetostriktion mit einer betragsmäßigen relativen Längenänderung parallel zum magnetischen Feld von weniger oder gleich 2 mal 10⁻⁶ auf, bevorzugt von weniger oder gleich 1 mal 10⁻⁶ und besonders bevorzugt von weniger oder gleich 0,5 mal 10⁻⁶.

### Begrifflich sei hierzu Folgendes erläutert:

Unter "Magnetostriktion" wird die Verformung des Dämpfungsmaterial infolge eines einwirkenden magnetischen Feldes verstanden. Dabei erfährt das Dämpfungsmaterial bei konstantem Volumen eine elastische Längenänderung.

Nach einem zweiten Aspekt der Erfindung löst die Aufgabe ein Gegenstand mit einer Batterie, einer Empfängerspule zum kabellosen Empfangen von Energie und einer Dämpfungsfolie nach dem ersten Aspekt der Erfindung.

Es versteht sich, dass sich die Vorteile einer Dämpfungsfolie nach dem ersten Aspekt der Erfindung, wie vorstehend beschrieben, unmittelbar auf einen Gegenstand mit einer Batterie, einer Empfängerspule zum kabellosen Empfangen von Energie und einer Dämpfungsfolie nach dem ersten Aspekt der Erfindung erstrecken. Bevorzugt ist die Dämpfungsfolie zwischen der Batterie und der Empfängerspule angeordnet.

Hierdurch kann die Batterie vorteilhaft durch die Dämpfungsfolie vor dem Einwirken eines elektrischen und/oder magnetischen Feldes geschützt werden.

Es sei ausdrücklich darauf hingewiesen, dass der Gegenstand des zweiten Aspekts mit dem Gegenstand des vorstehenden Aspekts der Erfindung vorteilhaft kombinierbar ist, und zwar sowohl einzeln oder in beliebiger Kombination kumulativ.

Nach einem dritten Aspekt der Erfindung löst die Aufgabe ein Gegenstand mit einer Sendespule zum kabellosen Senden von Energie an eine Empfängerspule und einer Dämpfungsfolie nach dem ersten Aspekt der Erfindung.

Es versteht sich, dass sich die Vorteile einer Dämpfungsfolie nach dem ersten Aspekt der Erfindung, wie vorstehend beschrieben, unmittelbar auf einen Gegenstand mit einer Sendespule zum kabellosen Senden von Energie an eine Empfängerspule und einer Dämpfungsfolie nach dem ersten Aspekt der Erfindung erstrecken.

Bevorzugt ist die Dämpfungsfolie auf der Sendespule angeordnet.

Es sei ausdrücklich darauf hingewiesen, dass der Gegenstand des dritten Aspekts mit den Gegenständen der vorstehenden Aspekte der Erfindung vorteilhaft kombinierbar werden kann, und zwar sowohl einzeln oder in beliebiger Kombination kumulativ.

Nach einem vierten Aspekt der Erfindung löst die Aufgabe ein Verfahren zum Herstellen einer Dämpfungsfolie, das Folgendes aufweist:
- Bereitstellen einer ersten Trägerschicht und einer ersten Adhäsionsschicht;
- ggf. Kontaktieren der ersten Trägerschicht und der ersten Adhäsionsschicht;
- Bereitstellen eines Dämpfungsmaterials bestehend aus einem weichmagnetischen Stoff;
- Kontaktieren des Dämpfungsmaterials mit der ersten Adhäsionsschicht zu einer mit der ersten Trägerschicht verbundenen Dämpfungsschicht;
- Bereitstellen einer zweiten Adhäsionsschicht und einer zweiten Trägerschicht;
- ggf. Kontaktieren der zweiten Trägerschicht und der zweiten Adhäsionsschicht; und
- Kontaktieren der zweiten Adhäsionsschicht mit der Dämpfungsschicht zu einer Dämpfungsfolie nach dem ersten Aspekt der Erfindung.

Es versteht sich, dass sich die Vorteile einer Dämpfungsfolie nach dem ersten Aspekt der Erfindung, wie vorstehend beschrieben, auf ein Verfahren zum Herstellen einer Dämpfungsfolie nach dem ersten Aspekt der Erfindung erstrecken.

Vorzugsweise sei daran gedacht, dass das Dämpfungsmaterial in Partikelform auf eine Adhäsionsschicht aufgesprüht wird, insbesondere eine Klebefolie aufgesprüht wird.

Es sei ausdrücklich darauf hingewiesen, dass der Gegenstand des vierten Aspekts mit den Gegenständen der vorstehenden Aspekte der Erfindung vorteilhaft kombinierbar werden kann, und zwar sowohl einzeln oder in beliebiger Kombination kumulativ.

Nach einem fünften Aspekt der Erfindung löst die Aufgabe eine Verwendung einer Dämpfungsfolie nach dem ersten Aspekt der Erfindung bei einem Gegenstand mit Komponenten zum kabellose Laden.

Es versteht sich, dass sich die Vorteile einer Dämpfungsfolie nach dem ersten Aspekt der Erfindung, wie vorstehend beschrieben, unmittelbar auf eine Verwendung einer Dämpfungsfolie nach dem ersten Aspekt der Erfindung bei einem Gegenstand mit Komponenten zum kabellose Laden erstrecken.

Es sei ausdrücklich darauf hingewiesen, dass der Gegenstand des fünften Aspekts mit den Gegenständen der vorstehenden Aspekte der Erfindung vorteilhaft kombinierbar werden kann, und zwar sowohl einzeln oder in beliebiger Kombination kumulativ.

Nach einem sechsten Aspekt der Erfindung löst die Aufgabe eine Verwendung einer Dämpfungsfolie nach dem ersten Aspekt der Erfindung bei einem Gegenstand mit abzuschirmenden Komponenten, insbesondere elektronischen Bauteilen, Kabeln und/oder Sensoren.

Es versteht sich, dass sich die Vorteile einer Dämpfungsfolie nach dem ersten Aspekt der Erfindung, wie vorstehend beschrieben, unmittelbar auf eine Verwendung einer Dämpfungsfolie nach dem ersten Aspekt der Erfindung bei einem Gegenstand mit abzuschirmenden Komponenten, insbesondere elektronischen Bauteilen, Kabeln und/oder Sensoren erstrecken.

Es sei ausdrücklich darauf hingewiesen, dass der Gegenstand des sechsten Aspekts mit den Gegenständen der vorstehenden Aspekte der Erfindung vorteilhaft kombinierbar werden kann, und zwar sowohl einzeln oder in beliebiger Kombination kumulativ.

Weitere Vorteile, Einzelheiten und Merkmale der Erfindung ergeben sich nachfolgend aus den erläuterten Ausführungsbeispielen.

Dabei zeigen im Einzelnen:
- Figur 1:: schematisch eine Dämpfungsfolie gemäß einer ersten Ausführungsform im Querschnitt;
- Figur 2:: schematisch eine Dämpfungsfolie gemäß einer ersten Ausführungsform in einer Schnittdarstellung; und
- Figur 3:: schematisch eine Dämpfungsfolie gemäß einer zweiten Ausführungsform in einer Schnittdarstellung in einer Detailansicht.

In der nun folgenden Beschreibung bezeichnen gleiche Bezugszeichen gleiche Bauteile bzw. gleiche Merkmale, sodass eine in Bezug auf eine Figur durchgeführte Beschreibung bezüglich eines Bauteils auch für die anderen Figuren gilt, sodass eine wiederholende Beschreibung vermieden wird. Ferner sind einzelne Merkmale, die in Zusammenhang mit einer Ausführungsform beschrieben wurden, auch separat in anderen Ausführungsformen verwendbar.

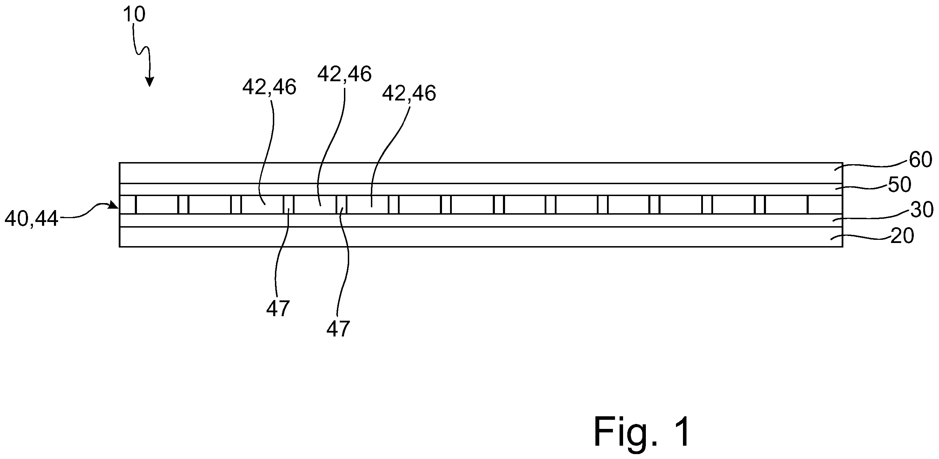

Die Dämpfungsfolie 10 in Figur 1 besteht im Wesentlichen aus einer ersten Trägerschicht 20, einer ersten Adhäsionsschicht 30, einer Dämpfungsschicht 40, einer zweiten Adhäsionsschicht 50 und einer zweiten Trägerschicht 60.

Die erste Adhäsionsschicht 30 ist mit der ersten Trägerschicht 20 und der Dämpfungsschicht 40 kontaktiert und verbindet diese miteinander.

Die zweite Adhäsionsschicht 50 ist mit der zweiten Trägerschicht 60 und der Dämpfungsschicht 40 kontaktiert und verbindet diese miteinander.

Die Dämpfungsschicht 40 weist eine Lage 44 eines Dämpfungsmaterials 42 auf, insbesondere ein Dämpfungsmaterial 42 aufweisend einen weichmagnetischen Stoff.

Das Dämpfungsmaterial 42 ist in Streifen 46 in der Lage 44 der Dämpfungsschicht 40 organisiert, wobei die Streifen 46 parallel zueinander angeordnet sind und benachbarte Streifen 46 einen Abstand 47 zueinander aufweisen.

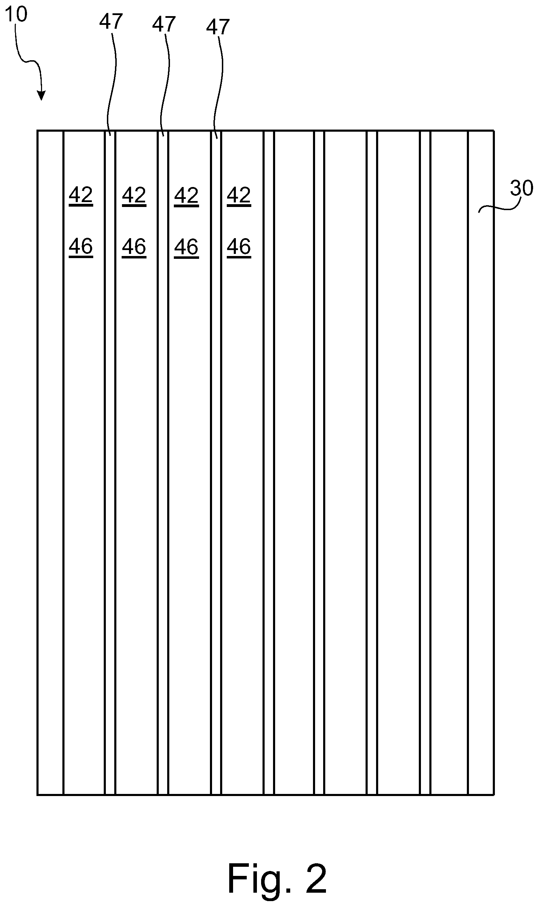

Figur 2 zeigt eine Schnittdarstellung der Ausführungsform der Dämpfungsfolie 10 aus Figur 1, wobei der Schnitt durch die Dämpfungsschicht (nicht bezeichnet) verläuft und somit eine Draufsicht auf die Streifen 46 in der Dämpfungsschicht 40 ermöglicht.

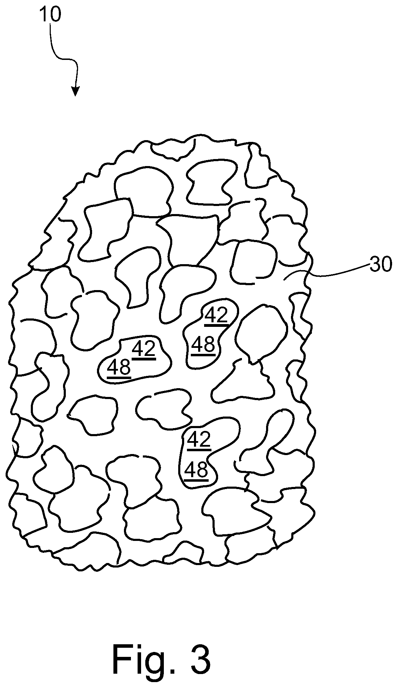

Die Dämpfungsfolie 10 in Figur 3 ist in einer Schnittdarstellung einer Detailansicht dargestellt, wobei der Schnitt durch die Dämpfungsschicht (nicht bezeichnet) verläuft. Die Dämpfungsschicht (nicht bezeichnet) weist das Dämpfungsmaterial 42 in Form von Partikeln 48 auf.

Die Partikel 48 bilden keine durchgängige Dämpfungsschicht (nicht bezeichnet), sondern weisen unregelmäßige Lücken (nicht bezeichnet) zueinander auf, sodass die erste Adhäsionsschicht 30 durch diese unregelmäßigen Lücken hindurch aufgewiesen wird.

### Bezugszeichenliste

- 10: Dämpfungsfolie
- 20: erste Trägerschicht
- 30: erste Adhäsionsschicht
- 40: Dämpfungsschicht
- 42: Dämpfungsmaterial
- 44: Lage
- 46: Streifen
- 47: Abstand
- 48: Partikel
- 50: zweite Adhäsionsschicht
- 60: zweite Trägerschicht

## Patentansprüche

1. Dämpfungsfolie (10), insbesondere Dämpfungsfolie (10) zur Abschirmung eines elektronischen Geräts vor einem elektrischen und/oder magnetischen Feld, insbesondere Dämpfungsfolie (10) zur Abschirmung eines elektronischen Geräts mit Komponenten zum kabellosen Laden vor einem elektrischen und/oder magnetischen Feld, aufweisend:
- eine erste Trägerschicht (20);
- eine erste Adhäsionsschicht (30), welche unmittelbar mit der ersten Trägerschicht (20) kontaktiert ist;
- eine Dämpfungsschicht (40), welche unmittelbar mit der ersten Adhäsionsschicht (30) kontaktiert ist, wobei die Dämpfungsschicht (40) ein Dämpfungsmaterial (42) bestehend aus einem weichmagnetischen Stoff aufweist;
- eine zweite Adhäsionsschicht (50), welche unmittelbar mit der Dämpfungsschicht (40) kontaktiert ist, insbesondere auf der abgewandten Seite der ersten Adhäsionsschicht (30) unmittelbar mit der Dämpfungsschicht (40) kontaktiert ist; und
- eine zweite Trägerschicht (60), welche unmittelbar mit der zweiten Adhäsionsschicht (50) kontaktiert ist,
**dadurch gekennzeichnet, dass**
das Dämpfungsmaterial (42) eine Koerzitivfeldstärke von kleiner oder gleich 2 A/m aufweist, bevorzugt eine Koerzitivfeldstärke von kleiner oder gleich 1,5 A/m und besonders bevorzugt eine Koerzitivfeldstärke von kleiner oder gleich 1 A/m.

2. Dämpfungsfolie (10) nach Anspruch 1, **dadurch gekennzeichnet, dass** das Dämpfungsmaterial (42) der Dämpfungsschicht (40) projiziert in Normalenrichtung der ersten Trägerschicht (20) eine Querschnittsfläche von mehr oder gleich 80 % der Querschnittsfläche der ersten Trägerschicht (20) aufweist, bevorzugt von mehr oder gleich 87,5 % und besonders bevorzugt von mehr oder gleich 92,5 %.

3. Dämpfungsfolie (10) nach einem der Ansprüche 1 oder 2, **dadurch gekennzeichnet, dass** die Dämpfungsschicht (40) eine Lage (44) aus mehreren Streifen (46) des Dämpfungsmaterials (42) aufweist.

4. Dämpfungsfolie (10) nach Anspruch 3, **dadurch gekennzeichnet, dass** zwei Streifen (46) des Dämpfungsmaterials (42) einen Abstand (47) von weniger oder gleich 0,2 mm zueinander aufweisen, bevorzugt einen Abstand (47) von weniger oder gleich 0,1 mm und besonders bevorzugt einen Abstand (47) von weniger oder gleich 0,05 mm.

5. Dämpfungsfolie (10) nach Anspruch 3, **dadurch gekennzeichnet, dass** zwei Streifen (46) des Dämpfungsmaterials (42) sich um mehr oder gleich 0,2 mm überlappen, bevorzugt um weniger als 0,2 mm überlappen und besonders bevorzugt um weniger oder gleich 0,1 mm überlappen.

6. Dämpfungsfolie (10) nach einem der vorstehenden Ansprüche, **dadurch gekennzeichnet, dass** die Dämpfungsschicht (40) Partikel (48) des Dämpfungsmaterials (42) aufweist.

7. Dämpfungsfolie (10) nach Anspruch 6, **dadurch gekennzeichnet, dass** die Partikel (48) eine Erstreckung in einem Bereich von größer oder gleich 3 µm und kleiner oder gleich 200 µm aufweisen, bevorzugt eine Erstreckung in einem Bereich von größer oder gleich 4 µm und kleiner oder gleich 100 µm und besonders bevorzugt eine Erstreckung in einem Bereich von größer oder gleich 5 µm und kleiner oder gleich 50 µm.

8. Dämpfungsfolie (10) nach einem der vorstehenden Ansprüche, **dadurch gekennzeichnet, dass** die Dämpfungsfolie (10) eine dritte Adhäsionsschicht aufweist, bevorzugt eine auf der abgewandten Seite der ersten Adhäsionsschicht (30) unmittelbar mit der ersten Trägerschicht (20) kontaktierte dritte Adhäsionsschicht.

9. Dämpfungsfolie (10) nach einem der vorstehenden Ansprüche, **dadurch gekennzeichnet, dass** die erste Trägerschicht (20) und/oder die zweite Trägerschicht (60) und/oder die erste Adhäsionsschicht (30) und/oder die zweite Adhäsionsschicht (50) und/oder die dritte Adhäsionsschicht eine Temperaturbeständigkeit von mehr oder gleich 80 °C aufweist, bevorzugt von mehr oder gleich 100 °C und besonders bevorzugt von mehr oder gleich 120 °C.

10. Dämpfungsfolie (10) nach einem der vorstehenden Ansprüche, **dadurch gekennzeichnet, dass** das Dämpfungsmaterial (42) eine Remanenz von kleiner oder gleich 0,1 T aufweist, bevorzugt eine Remanenz von kleiner oder gleich 0,05 T und besonders bevorzugt eine Remanenz von kleiner oder gleich 0,02 T.

11. Dämpfungsfolie (10) nach einem der vorstehenden Ansprüche, **dadurch gekennzeichnet, dass** das Dämpfungsmaterial (42) eine Sättigungsflussdichte von größer oder gleich 1 T aufweist, bevorzugt eine Sättigungsflussdichte von größer oder gleich 1,1 T und besonders bevorzugt eine Sättigungsflussdichte von größer oder gleich 1,2 T.

12. Dämpfungsfolie (10) nach einem der vorstehenden Ansprüche, **dadurch gekennzeichnet, dass** der weichmagnetische Stoff ein metallisches Glas ist.

13. Dämpfungsfolie (10) nach Anspruch 12, **dadurch gekennzeichnet, dass** der weichmagnetische Stoff eine nanokristalline Struktur aufweist.

14. Dämpfungsfolie (10) nach einem der vorstehenden Ansprüche, **dadurch gekennzeichnet, dass** der weichmagnetische Stoff folgende atomare Zusammensetzung aufweist:
[Fe₁₋ₐNiₐ]_{100-x-y-z-α-β-γ} CuₓSi_{y}B_{z}Nb_{α}M'_{β}M"_{γ}
mit a ≤ 0,3, 0,6 ≤ x ≤ 1,5, 10 ≤ y ≤ 17, 5 ≤ z ≤ 14, 2 ≤ α ≤ 6, β ≤ 7, γ ≤ 8, wobei M' mindestens eines der Elemente V, Cr, Co, Al und Zn ist, wobei M" mindestens eines der Elemente C, Ge, P, Ga, Sb, In und Be ist.

15. Dämpfungsfolie (10) nach einem der vorstehenden Ansprüche, **dadurch gekennzeichnet, dass** der weichmagnetische Stoff eine Magnetostriktion mit einer betragsmäßigen relativen Längenänderung parallel zum magnetischen Feld von weniger oder gleich 2 mal 10⁻⁶ aufweist, bevorzugt von weniger oder gleich 1 mal 10⁻⁶ und besonders bevorzugt von weniger oder gleich 0,5 mal 10⁻⁶.

16. Gegenstand mit einer Batterie, einer Empfängerspule zum kabellosen Empfangen von Energie und einer Dämpfungsfolie (10) nach einem der Ansprüche 1 bis 15.

17. Gegenstand nach Anspruch 16, wobei die Dämpfungsfolie (10) zwischen der Batterie und der Empfängerspule angeordnet ist.

18. Gegenstand mit einer Sendespule zum kabellosen Senden von Energie an eine Empfängerspule und einer Dämpfungsfolie (10) nach einem der Ansprüche 1 bis 15.

19. Gegenstand nach Anspruch 18, wobei die Dämpfungsfolie (10) auf der Sendespule angeordnet ist.

20. Verfahren zum Herstellen einer Dämpfungsfolie (10), das Folgendes aufweist:
- Bereitstellen einer ersten Trägerschicht (20) und einer ersten Adhäsionsschicht (30);
- ggf. Kontaktieren der ersten Trägerschicht (20) und der ersten Adhäsionsschicht (30);
- Bereitstellen eines Dämpfungsmaterials (42) bestehend aus einem weichmagnetischen Stoff;
- Kontaktieren des Dämpfungsmaterials (42) mit der ersten Adhäsionsschicht (30) zu einer mit der ersten Trägerschicht (20) verbundenen Dämpfungsschicht (40);
- Bereitstellen einer zweiten Adhäsionsschicht (50) und einer zweiten Trägerschicht (60);
- ggf. Kontaktieren der zweiten Trägerschicht (60) und der zweiten Adhäsionsschicht (50); und
- Kontaktieren der zweiten Adhäsionsschicht (50) mit der Dämpfungsschicht (40) zu einer Dämpfungsfolie (10) nach einem der Ansprüche 1 bis 15.

21. Verwendung einer Dämpfungsfolie (10) nach einem der Ansprüche 1 bis 15 bei einem Gegenstand mit Komponenten zum kabellose Laden oder bei einem Gegenstand mit abzuschirmenden Komponenten, insbesondere elektronischen Bauteilen, Kabeln und/oder Sensoren.

## Claims

1. Damping film (10), in particular a damping film (10) for shielding an electronic device from an electric and/or magnetic field, in particular a damping film (10) for shielding an electronic device with components for wireless charging from an electric and/or magnetic field, comprising:
- a first support layer (20);
- a first adhesion layer (30) in direct contact with the first support layer (20);
- a damping layer (40) in direct contact with the first adhesion layer (30), wherein the damping layer (40) comprises a damping material (42) consisting of a soft magnetic material;
- a second adhesion layer (50) in direct contact with the damping layer (40), in particular in direct contact with the damping layer (40) on the opposite side of the first adhesion layer (30); and
- a second support layer (60) in direct contact with the second adhesion layer (50),
**characterized in that**
the damping material (42) has a coercive force of less than or equal to 2 A/m, preferably a coercive force of less than or equal to 1.5 A/m and particularly preferably a coercive force of less than or equal to 1 A/m.

2. Damping film (10) according to Claim 1, **characterized in that** the damping material (42) of the damping layer (40), projected in the normal direction of the first support layer (20), has a cross-sectional area of greater than or equal to 80% of the cross-sectional area of the first support layer (20), preferably of greater than or equal to 87.5% and particularly preferably of greater than or equal to 92.5%.

3. Damping film (10) according to either of Claims 1 or 2, **characterized in that** the damping layer (40) has a layer (44) comprising a plurality of strips (46) of the damping material (42) .

4. Damping film (10) according to Claim 3, **characterized in that** two strips (46) of the damping material (42) have a distance (47) from one another of less than or equal to 0.2 mm, preferably a distance (47) of less than or equal to 0.1 mm, and particularly preferably a distance (47) of less than or equal to 0.05 mm.

5. Damping film (10) according to Claim 3, **characterized in that** two strips (46) of the damping material (42) overlap by greater than or equal to 0.2 mm, preferably overlap by less than 0.2 mm, and particularly preferably overlap by less than or equal to 0.1 mm.

6. Damping film (10) according to any of the preceding claims, **characterised in that** the damping layer (40) comprises particles (48) of the damping material (42).

7. Damping film (10) according to Claim 6, **characterised in that** the particles (48) have an extent in a range of greater than or equal to 3 um and less than or equal to 200 µm, preferably an extent in a range of greater than or equal to 4 um and less than or equal to 100 um and particularly preferably an extent in a range of greater than or equal to 5 um and less than or equal to 50 µm.

8. Damping film (10) according to any of the preceding claims, **characterized in that** the damping film (10) has a third adhesion layer, preferably a third adhesion layer which is in direct contact with the first support layer (20) on the side facing away from the first adhesion layer (30).

9. Damping film (10) according to any of the preceding claims, **characterized in that** the first support layer (20) and/or the second support layer (60) and/or the first adhesion layer (30) and/or the second adhesion layer (50) and/or the third adhesion layer has a temperature resistance of greater than or equal to 80°C, preferably of greater than or equal to 100°C and particularly preferably of greater than or equal to 120°C.

10. Damping film (10) according to any of the preceding claims, **characterized in that** the damping material (42) has a remanence of less than or equal to 0.1T, preferably a remanence of less than or equal to 0.05T and particularly preferably a remanence of less than or equal to 0.02T.

11. Damping film (10) according to any of the preceding claims, **characterized in that** the damping material (42) has a saturation flux density of greater than or equal to 1T, preferably a saturation flux density of greater than or equal to 1.1T and particularly preferably a saturation flux density of greater than or equal to 1.2T.

12. Damping film (10) according to any of the preceding claims, **characterized in that** the soft magnetic material is a metallic glass.

13. Damping film (10) according to Claim 12, **characterized in that** said soft magnetic material has a nanocrystalline structure.

14. Damping film (10) according to any of the preceding claims, **characterized in that** the soft magnetic material has the following atomic composition:
[Fei₁₋ₐNiₐ]_{100-x-y-z-α-β-γ} CUₓSi_{y}B_{z}Nb_{α}M'_{β}M"_{γ}
where a ≤ 0.3, 0.6 ≤ x ≤ 1.5, 10 ≤ y ≤ 17, 5 ≤ z ≤ 14, 2 ≤ α ≤ 6, β ≤ 7, γ ≤ 8, wherein M' is at least one of the elements V, Cr, Co, Al, and Zn, where M" is at least one of the elements C, Ge, P, Ga, Sb, In, and Be.

15. Damping film (10) according to any of the preceding claims, **characterized in that** the soft magnetic material has a magnetostriction with an absolute relative change in length parallel to the magnetic field of less than or equal to 2 times 10⁻⁶, preferably of less than or equal to 1 times 10⁻⁶ and particularly preferably of less than or equal to 0.5 times 10⁻⁶.

16. Article comprising a battery, a receiver coil for wirelessly receiving energy and a damping film (10) according to any of Claims 1 to 15.

17. Article according to Claim 16, wherein the damping film (10) is disposed between the battery and the receiver coil.

18. Article comprising a transmitter coil for the wireless transmission of energy to a receiver coil and a damping film (10) according to any one of Claims 1 to 15.

19. Article according to Claim 18, wherein the damping film (10) is disposed on the transmitter coil.

20. Method of producing a damping film (10), comprising:
- Providing a first support layer (20) and a first adhesion layer (30);
- optionally contacting the first support layer (20) and the first adhesion layer (30);
- Providing a damping material (42) consisting of a soft magnetic material;
- Contacting the damping material (42) with the first adhesion layer (30) to form a damping layer (40) connected to the first support layer (20);
- Providing a second adhesion layer (50) and a second support layer (60);
- optionally contacting the second support layer (60) and the second adhesion layer (50); and
- Contacting the second adhesion layer (50) with the damping layer (40) to form a damping film (10) according to any of Claims 1 to 15.

21. Use of a damping film (10) according to any of Claims 1 to 15 in an article having components for wireless charging or in an article having components to be shielded, in particular electronic components, cables and/or sensors.

## Revendications

1. Film d'amortissement (10), en particulier film d'amortissement (10) pour protéger un appareil électronique d'un champ électrique et/ou magnétique, en particulier film d'amortissement (10) pour protéger un appareil électronique avec des composants pour la charge sans fil d'un champ électrique et/ou magnétique, comprenant :
- une première couche de support (20) ;
- une première couche d'adhérence (30) directement en contact avec la première couche de support (20) ;
- une couche d'amortissement (40) qui est directement en contact avec la première couche d'adhérence (30), la couche d'amortissement (40) comprenant un matériau d'amortissement (42) constitué d'un matériau magnétique doux ;
- une deuxième couche d'adhérence (50) qui est directement en contact avec la couche d'amortissement (40), en particulier sur le côté opposé de la première couche d'adhérence (30) qui est directement en contact avec la couche d'amortissement (40) ; et
- une deuxième couche de support (60) qui est directement en contact avec la deuxième couche d'adhérence (50),
**caractérisé en ce que**
le matériau d'amortissement (42) a une intensité de champ coercitif inférieure ou égale à 2 A/m, de préférence une intensité de champ coercitif inférieure ou égale à 1,5 A/m et de manière particulièrement préférée une intensité de champ coercitif inférieure ou égale à 1 A/m.

2. Film d'amortissement (10) selon la revendication 1, **caractérisé en ce que** le matériau d'amortissement (42) de la couche d'amortissement (40) projeté dans la direction normale de la première couche de support (20) présente une surface en section transversale supérieure ou égale à 80 % de la surface en section transversale de la première couche de support (20), de préférence supérieure ou égale à 87,5 % et plus préférentiellement supérieure ou égale à 92,5 %.

3. Film d'amortissement (10) selon l'une quelconque des revendications 1 ou 2, **caractérisé en ce que** la couche d'amortissement (40) présente une couche (44) de plusieurs bandes (46) du matériau d'amortissement (42).

4. Film d'amortissement (10) selon la revendication 3, **caractérisé en ce que** deux bandes (46) du matériau d'amortissement (42) présentent entre elles une distance (47) inférieure ou égale à 0,2 mm, de préférence une distance (47) inférieure ou égale à 0,1 mm et plus préférentiellement une distance (47) inférieure ou égale à 0,05 mm.

5. Film d'amortissement (10) selon la revendication 3, **caractérisé en ce que** deux bandes (46) du matériau d'amortissement (42) se chevauchent de plus ou égale à 0,2 mm, se chevauchent de préférence de moins de 0,2 mm et se chevauchent de manière particulièrement préférée de moins ou égale à 0,1 mm.

6. Film d'amortissement (10) selon l'une quelconque des revendications précédentes, **caractérisé en ce que** la couche d'amortissement (40) comprend des particules (48) du matériau d'amortissement (42).

7. Film d'amortissement (10) selon la revendication 6, **caractérisé en ce que** les particules (48) ont une extension dans une plage supérieure ou égale à 3 um et inférieure ou égale à 200 um, de préférence une extension dans une plage supérieure ou égale à 4 um et inférieure ou égale à 100 um, et plus préférentiellement une extension dans une plage supérieure ou égale à 5 um et inférieure ou égale à 50 µm.

8. Film d'amortissement (10) selon l'une quelconque des revendications précédentes, **caractérisé en ce que** le film d'amortissement (10) présente une troisième couche d'adhérence, de préférence une troisième couche d'adhérence directement en contact avec la première couche de support (20) sur le côté opposé de la première couche d'adhérence (30).

9. Film d'amortissement (10) selon l'une quelconque des revendications précédentes, **caractérisé en ce que** la première couche de support (20) et/ou la deuxième couche de support (60) et/ou la première couche d'adhérence (30) et/ou la deuxième couche d'adhérence (50) et/ou la troisième couche d'adhérence présente une résistance à la température supérieure ou égale à 80 °C, de préférence supérieure ou égale à 100 °C et plus préférentiellement supérieure ou égale à 120 °C.

10. Film d'amortissement (10) selon l'une quelconque des revendications précédentes, **caractérisé en ce que** le matériau d'amortissement (42) présente une rémanence inférieure ou égale à 0,1 T, de préférence une rémanence inférieure ou égale à 0,05 T et plus préférentiellement une rémanence inférieure ou égale à 0,02 T.

11. Film d'amortissement (10) selon l'une quelconque des revendications précédentes, **caractérisé en ce que** le matériau d'amortissement (42) présente une densité de flux de saturation supérieure ou égale à 1 T, de préférence une densité de flux de saturation supérieure ou égale à 1,1 T et plus préférentiellement une densité de flux de saturation supérieure ou égale à 1,2 T.

12. Film d'amortissement (10) selon l'une quelconque des revendications précédentes, **caractérisé en ce que** le matériau magnétique doux est un verre métallique.

13. Film d'amortissement (10) selon la revendication 12, **caractérisé en ce que** le matériau magnétique doux présente une structure nanocristalline.

14. Film d'amortissement (10) selon l'une quelconque des revendications précédentes, **caractérisé en ce que** le matériau magnétique doux a la composition atomique suivante :
[Fei₁₋ₐNiₐ]_{100-x-y-z-α-β-γ} CUₓSi_{y}B_{z}Nb_{α}M'_{β}M"_{γ}
avec a ≤ 0,3, 0,6 ≤ x ≤ 1,5, 10 ≤ y ≤ 17, 5 ≤ z ≤ 14, 2 ≤ α ≤ 6, B ≤ 7, γ ≤ 8, où M'est au moins un des éléments V, Cr, Co, Al et Zn, où M" est au moins un des éléments C, Ge, P, Ga, Sb, In et Be.

15. Film d'amortissement (10) selon l'une quelconque des revendications précédentes, **caractérisé en ce que** le matériau magnétique doux présente une magnétostriction avec une variation de longueur relative en valeur, parallèle au champ magnétique, inférieure ou égale à 2 fois 10⁻⁶, de préférence inférieure ou égale à 1 fois 10⁻⁶ et plus préférentiellement inférieure ou égale à 0,5 fois 10⁻⁶.

16. Objet comprenant une batterie, une bobine réceptrice pour recevoir de l'énergie sans fil et un film d'amortissement (10) selon l'une quelconque des revendications 1 à 15.

17. Objet selon la revendication 16, dans lequel le film d'amortissement (10) est disposé entre la batterie et la bobine réceptrice.

18. Objet comprenant une bobine émettrice pour l'envoi sans fil d'énergie à une bobine réceptrice et un film d'amortissement (10) selon l'une quelconque des revendications 1 à 15.

19. Objet selon la revendication 18, dans lequel le film d'amortissement (10) est disposé sur la bobine émettrice.

20. Procédé de fabrication d'un film d'amortissement (10) comprenant :
- Mise à disposition d'une première couche de support (20) et d'une première couche d'adhérence (30) ;
- le cas échéant, mise en contact de la première couche de support (20) et de la première couche d'adhérence (30) ;
- fourniture d'un matériau d'amortissement (42) constitué d'un matériau magnétique doux ;
- mise en contact du matériau d'amortissement (42) avec la première couche d'adhérence (30) pour former une couche d'amortissement (40) reliée à la première couche de support (20) ;
- fourniture d'une deuxième couche d'adhérence (50) et une deuxième couche de support (60) ;
- le cas échéant, mise en contact de la deuxième couche de support (60) et de la deuxième couche d'adhérence (50) ; et
- mise en contact de la deuxième couche d'adhérence (50) avec la couche d'amortissement (40) pour former un film d'amortissement (10) selon l'une quelconque des revendications 1 à 15.

21. Utilisation d'un film d'amortissement (10) selon l'une quelconque des revendications 1 à 15 sur un objet comportant des composants de chargement sans fil ou sur un objet comportant des composants à protéger, notamment des composants électroniques, des câbles et/ou des capteurs.
